# EUROPEAN PATENT SPECIFICATION

(11) **EP 3 268 274 B1**
(45) Date of publication and mention of the grant of the patent: **18.08.2021**
(21) Application number: 16760981.7
(22) Date of filing: 10.03.2016
(51) Int. Cl.: B64B 1/50, B64F 1/14, B64F 3/00, E04F 10/02, G09F 21/06, H01L 31/042, H02S 10/40

(54) **MOBILE ARTIFICIAL CLOUD**
MOBILE KÜNSTLICHE WOLKE
NUAGE ARTIFICIEL MOBILE

(30) Priority: 10.03.2015 US 201562130700 P
(43) Date of publication of application: 17.01.2018
(73) Proprietor: Paulus, Antoine Marcel, Surrey, British Columbia V3S 8T2 (CA)
(72) Inventor: Paulus, Antoine Marcel, Surrey, British Columbia V3S 8T2 (CA)
(74) Representative: Kehl, Ascherl, Liebhoff & Ettmayr Patentanwälte Partnerschaft mbB
(86) International application number: PCT/CA2016/050260
(87) International publication number: WO 2016/141484

(56) References cited:
- WO-A1-01/04436
- CA-A1- 2 004 980
- DE-A1- 2 445 875
- DE-A1- 3 829 845
- DE-A1- 3 829 845
- DE-A1- 10 220 529
- DE-A1- 10 220 529
- DE-A1- 10 261 746
- DE-A1- 10 261 746
- JP-A- H0 468 179
- JP-A- H0 468 179
- JP-B2- 2 834 386
- US-A- 5 478 407
- US-A1- 2010 018 566
- US-A1- 2010 018 566
- US-A1- 2010 123 040
- US-A1- 2010 123 040
- US-A1- 2011 315 811
- US-A1- 2014 270 795

## Description

### Field of the Invention

This invention relates to mobile artificial clouds. More specifically, the invention relates to a mobile formation of horizontally extending panels which are elevated above the ground for providing shade, and which can be formed of, laminated with, or covered by, thin and light photovoltaic flexible cells or any such product which would convert solar energy to electrical energy (electricity) for distribution through an electrical grid. The panels can take the form of gas-filled, flattened, large balloons, or sheets of material that may be elevated by balloons or releasably connected to fixed structures.

### Background of the Invention

Many areas of the world are subjected to high temperatures and significant sun exposure. For example, in Middle Eastern countries, daily high temperatures can reach almost 50 degrees Celsius, with average daily highs of more than 30 degrees Celsius. On average, there may be more than 3,500 hours of sunshine a year. This amount of sunshine, combined with the high temperatures, can make life uncomfortable for those exposed to it. In these areas, people would benefit from increased shade, which would assist in lowering the ambient temperature. At the same time, the sunshine is a readily available source of energy. With global population continuing to rise, new sources of energy are constantly being developed to meet the rising need for energy. Particular focus has been directed towards new, environmentally-friendly ways to generate electricity. Historically, electricity was generated through fossil fuel burning stations or nuclear facilities. More environmentally-friendly alternatives include hydroelectric plants; however, these require the availability of suitable waterways, which are not always available in many parts of the world.

More recently, attention has been focused on wind, wave, and solar alternatives. Large wind turbines have been developed, as have solar farms where large-scale photovoltaic systems supply power into the electricity grid. These solar farms are ground-mounted, with the solar arrays typically fixed-tilt or tracking (in either single or dual axes). Because they are ground-mounted, they require and occupy large areas of vacant land.

CA 2004980 A1 discloses a photovoltaic system having the technical features listed in the preamble part of claim 1. Therein, the known system employs solar panels having a glass pane, which are susceptible to damage during transport, mounting and dismounting. The solar panels are arranged in the design of a chess board.

US 5,478,407 discloses an apparatus for shading surfaces having a spread roof sheathing and photovoltaic elements laid out side by side.

W 01/04436 A1 discloses a cable and panel fabric for sheltering. The system described therein does not use the energy of immitted solar light.

It is an object of this invention to provide a system that allows better handling and efficiency to be employed as a mobile artificial cloud than the prior art does provide.

Further objects of the invention will be apparent from detailed description and claims.

### Summary of the Invention

The present invention provides a mobile cloud system according to claim 1.

Advantageous embodiments of the invention may be configured according to any of the dependent claims.

### Brief Description of the Drawings

These and other features of the invention will become more apparent from the following description in which reference is made to the appended drawings and wherein:
Fig. 1 shows a top view of an embodiment of a mobile cloud system according to the invention;
Fig. 2 is a side view of the mobile cloud system shown in Fig. 1 ;
Fig. 3 is a top view of an embodiment of an individual cloud shown in Fig. 1;
Fig. 4 is a top view of an alternative embodiment of a mobile cloud system according to the invention;
Fig. 5 is a perspective view of the mobile cloud system shown in Fig. 4;
Fig. 6 is a top view showing a pair of individual clouds connected to one another;
Fig. 7 is a perspective view of a further alternative embodiment of a mobile cloud system according to the invention;
Fig. 8 is a side view of a further alterative embodiment of a mobile cloud system;
Fig. 9 is a perspective view of the mobile cloud system shown in Fig. 8;
Fig. 10 is a perspective view of a further alternative embodiment of a mobile cloud system;
Fig. 11 is a perspective view of a mobile cloud system installed over a stadium; and
Fig. 12 is a perspective view of a mobile cloud system installed over a highway and metro station.

### Detailed Description of the Invention

The following detailed description should be read with reference to the drawings. The drawings, which are not to scale, depict illustrative embodiments and are not intended to limit the scope of the invention.

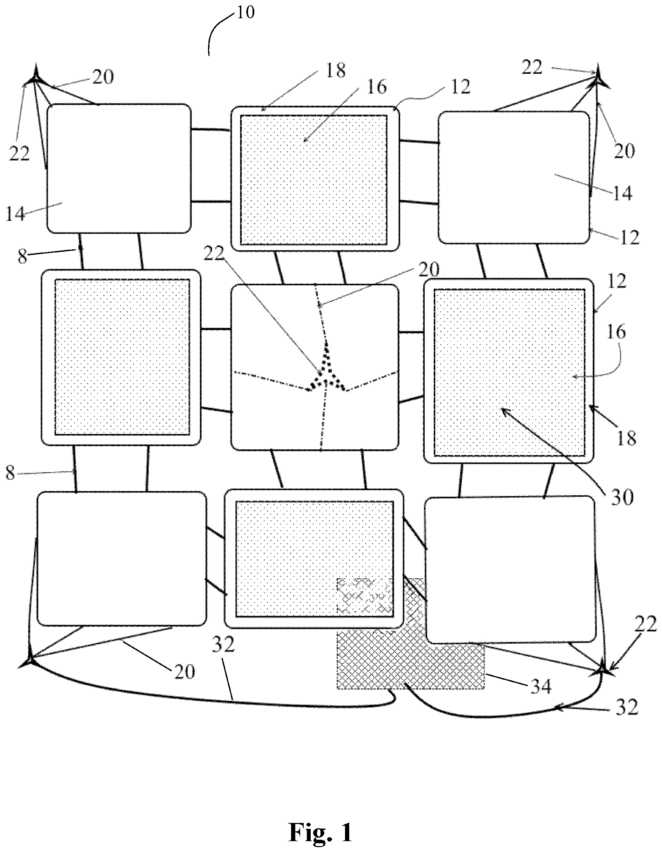

The preferred embodiment of a mobile artificial cloud system 10 according to the invention is shown in Fig. 1. The mobile cloud system 10 is preferably comprised of a plurality of individual clouds 12 in the form of horizontally extended panels. Individual clouds or panels 12 are preferably either a gas-filled balloon 14 or a sheet 16 of material. Preferably, the balloons 14 are in the form of large flattened balloons 14, such that their lengths and widths are much greater than their heights. The balloons 14 may be made of similar material as those found in conventional weather balloons. The sheets 16 can be made of any suitable material of sufficient strength. Preferably, the material is lightweight. Examples of appropriate materials include a plastic composite or the like. The material may also be perforated (or micro-perforated) to allow for some air to pass through the sheets 16 when there are heavy winds. This could prevent the sheets 16 from being tossed about and would help the sheets 16 in adjusting positions during flight.

In another embodiment, the sheets 16 may be formed from wind barrier nets or wind protection netting (similar to those used for plants). Such materials can block a significant portion of any wind passing through them, which may help in providing lift to the clouds 12 and in avoiding turbulence.

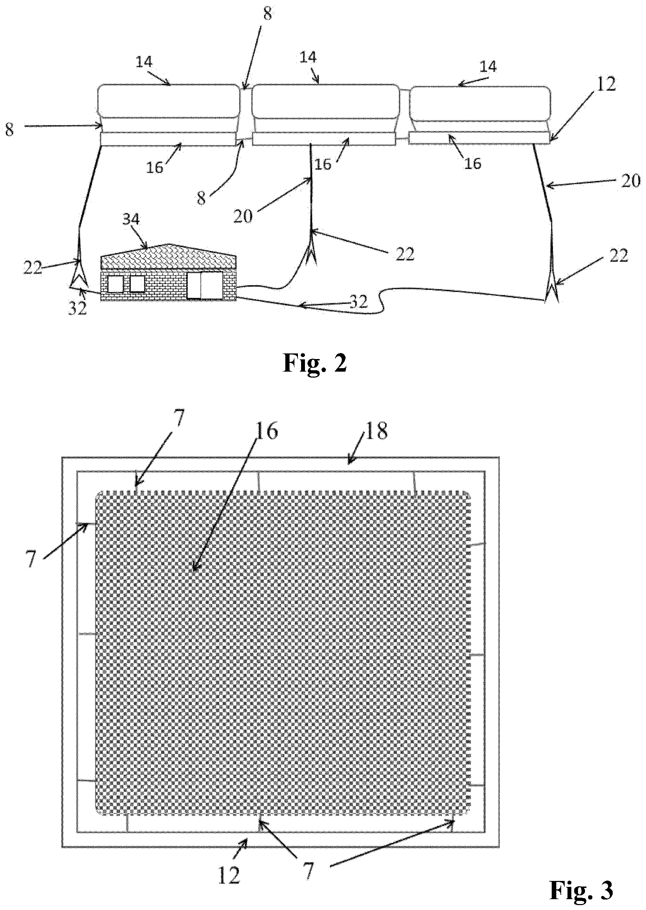

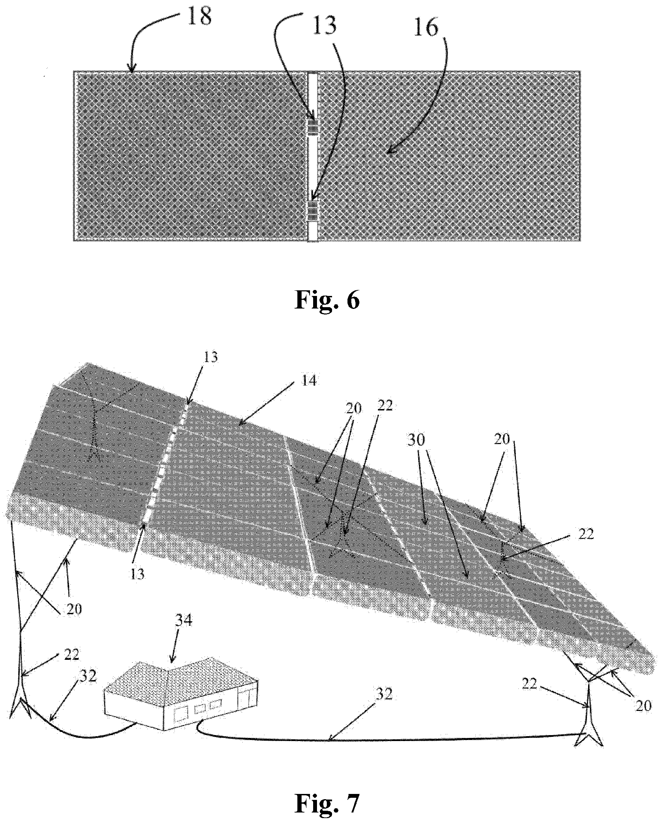

The sheets 16 may be surrounded by and connected to a substantially rigid frame 18. While not required in all circumstances, it is also contemplated that the balloons 14 could be surrounded by and connected to the frame 18. The frame 18 can be manufactured from any suitable material such as a composite plastic or the like. Preferably, this material is light, strong, and capable of some flex (for example, like a pole vault pole or the wings of an aircraft like the Airbus A380 or the solar impulse plane). In addition, the frame 18, and the respective individual clouds 12 connected thereto, can take any shape desired, whether oval, rectangle, square, circle, or other. As shown in Fig. 3, the individual clouds 12 are preferably connected to the frame 18 via frame connectors 7. The frame connectors 7 may be cords, cables, heavy-duty steel links, or the like, and they serve to hold the individual clouds 12 rigidly in place within the frame 18. The frame 18 can also be in the form of a number of a skeletal frame-like structures (such as in a honeycomb format as shown in Fig. 6), which would make it very light and easy to add any fabric or material to it, such as photovoltaic (PV) cell fabric. Such skeletal frame-like structures may include one or more hinges 13 to allow for folding and unfolding of the structures for transport. One or more of such units could also form a cloud 12. The frame 18 may also be equipped with a rubber surface or rubber or impact absorbing spacers along its outer edge to absorb any contact with adjacent frames 18.

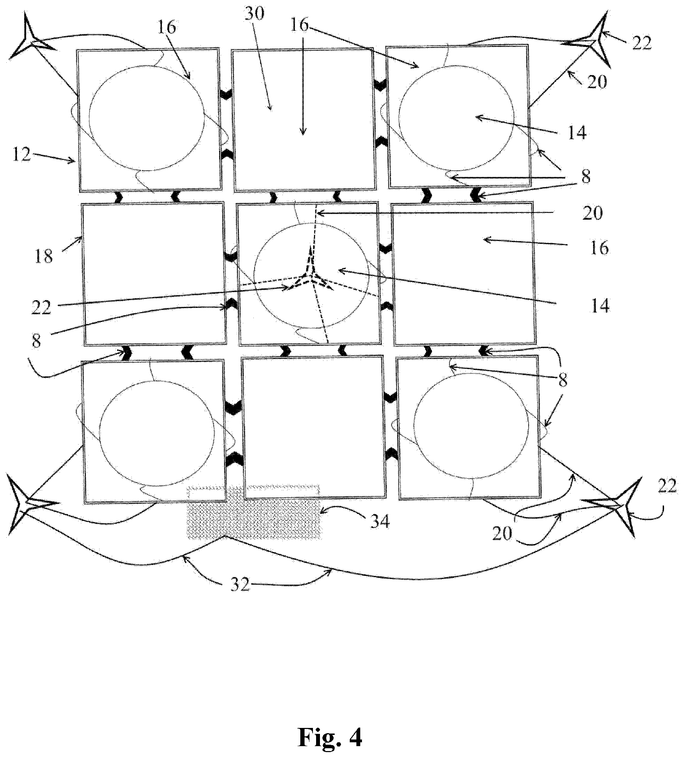

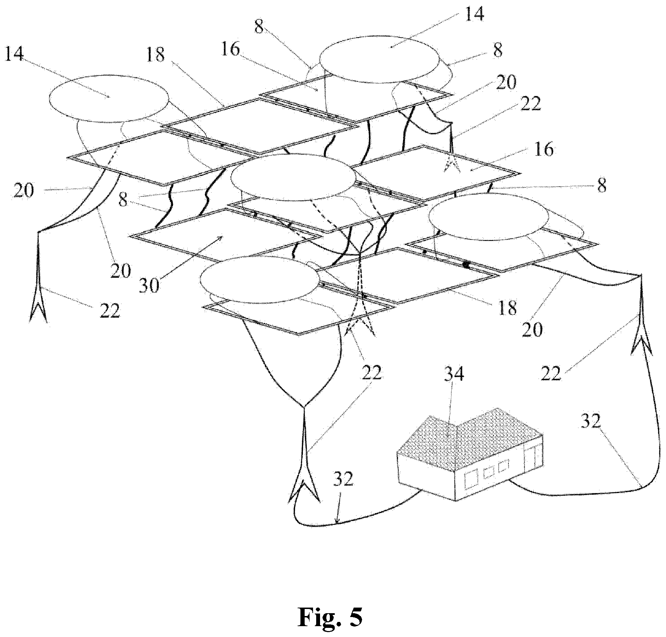

A plurality of individual clouds 12 may be interconnected with connectors 8, such as parachute cords, steel cables, heavy duty steel links or hinges, or the like, either from the edges or through cleats along the sides or other suitable connection system. The individual clouds 12 are tethered to each other in order to form the generally horizontally extending mobile artificial cloud system 10. The ultimate size and shape of the mobile artificial cloud system 10 can be varied as desired for any given application. In addition, a given mobile cloud system 10 can be comprised of either a plurality of sheets 16, or a plurality of balloons 14, or any combination of the two. For example, in Fig. 1, balloons 14 are located in the corners and the center of the mobile cloud system 10, with sheets 16 comprising the remaining panels. For a mobile cloud system 10 comprised primarily of sheets 16, larger external balloons 14 may be connected to provide the desired lift to the mobile cloud system 10, as shown in Figs. 4 and 5.

Once aloft, the mobile cloud system 10 can be maneuvered to a desired location to provide shade and anchored in place. As shown in Figs. 2, 5, 7, and 8, the mobile cloud system 10 may be tethered to the ground so as to both set a given height for the cloud system 10 and to limit horizontal movement. This can be accomplished in a number of ways depending on the use being made of the cloud system 10 and the location. For example, the mobile cloud system 10 may be tethered to a portable telescopic tower (e.g. mobile masts used in cellular telephone systems). Such telescopic towers may be moved from one location to another and can be of various heights.

When tethered to the ground via one or more cables 20, the cables 20 need to be connected in a suitable pattern to limit movement of the mobile cloud system 10 in the horizontal plane. As shown in Figs. 1 and 2, with a simple rectangular cloud system 10, cables 20 extending from the plurality of clouds 12, preferably from points along the perimeter and possibly at an angle, are connected to one or more ground anchors 22. The angle used may be dependent on wind conditions. Furthermore, the angle is not necessarily fixed and may be subject to change, depending on the atmospheric conditions. Although the tethering limits movement of the mobile cloud system 10, some movement may be allowed in order to reduce the stress on the cables 20 and the ground anchors 22.

However, the cables 20 may also extend from any other suitable point from the plurality of clouds 12. The ground anchors 22 are preferably positioned outside the (horizontal) extended rectangular footprint of the plurality of clouds 12. Depending on the size of the cloud system 10 and the number of individual clouds 12, additional tethers may be required in order to maintain the horizontal orientation; for example, in Fig. 2, an additional ground anchor 22 is tethered (through cable 20) to one of the balloons 14 located proximate to the middle of the cloud system 10.

Ground anchors 22 may take the form of a suitable weight or hook anchored to the ground, or they may be a free-standing structure. The free-standing structure could take the form of a pylon specifically erected for connection with a mobile cloud 10 or a pre-existing structure such as a lamp post, building, or other fixed structure having a portion elevated above ground level to which the mobile cloud system 10 can be anchored. Connecting to a fixed structure allows the mobile cloud system 10 to be held firmly in its extended horizontally extending form.

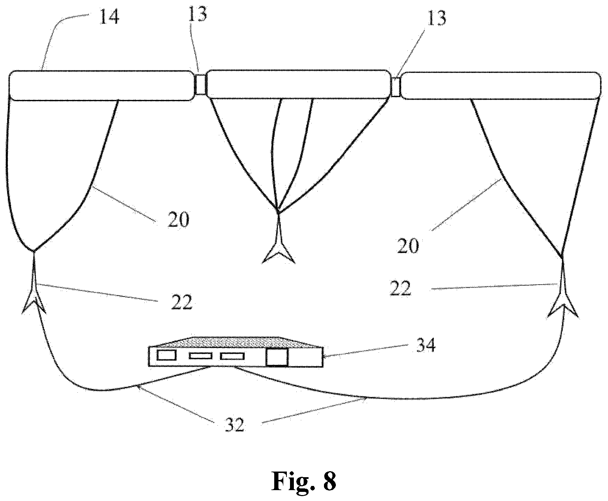

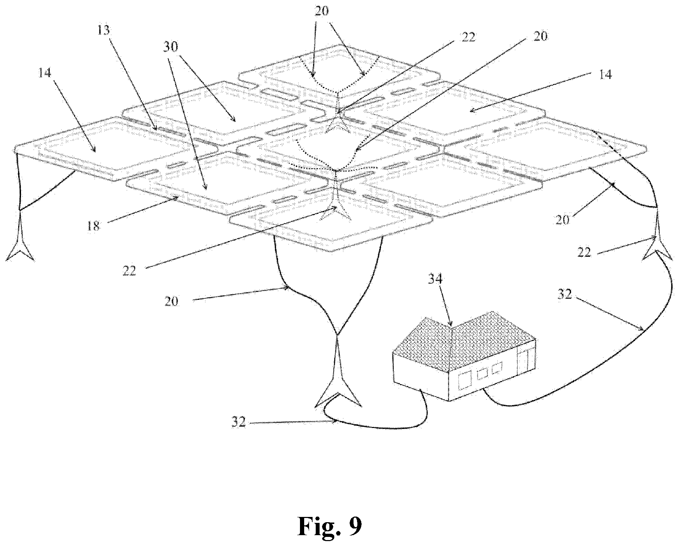

The orientation of a given cloud can also be controlled. For example, the embodiment of the mobile cloud system 10 shown in Fig. 7 comprises a plurality of balloons 14 connected to one another via hinges 13 and coated with PV material. The balloons 14 are anchored to anchors 22 through cables 20 and wired to a ground station 34. The orientation of the cloud system 10 can be controlled by controlling the length of the cables 20 from the anchors 22 to the balloons 14. In this case, the cables 20 on one side of the cloud system 10 are much longer than on the other side, resulting in the entire cloud system 10 being tilted (away from horizontal). This may be desired to better track the sun or to deal with wind or other factors. In Figs. 8 and 9, the mobile cloud system 10 is shown in a more level arrangement.

The mobile cloud system 10 can also be set up and launched in a variety of ways. For example, the mobile cloud system 10 can be assembled in a large open area, with the various individual clouds 12 being first laid out in a desired pattern and interconnected (with connectors 8) as required. The anchors 22 and the cables 20 may also be arranged and connected as well. Once all the individual clouds 12 are properly connected and anchored to the ground, the balloons 14 are inflated with sufficient amounts of a lighter-than-air gas to provide enough lift to raise the mobile cloud system 10 to a desired height. Initially, the anchors 22 would prevent any significant lift so that all the balloons 14 can be filled with the required amount. Once suitably inflated, the mobile cloud system 10 can be elevated to a desired height by letting out the various cables 20, by winch or other similar device. In one embodiment, the anchors 22 will slowly reel out, or extend, the length of the cables 20 between the anchors 22 and the clouds 12 as the balloons 14 are being inflated. This will allow the positioning and inflation of the balloons 14 to proceed in a more controlled manner. This will also prevent the warping and entanglement of the cables 20.

Should it be desired, the mobile cloud system 10 can be disconnected from the ground and moved via zeppelin or drones or other suitable motorized method in the air when it is desired to do so, or in the case where the clouds 12 are so large that it takes more time to bring down and relocate. They could even be connected via cables 20 to a land-based vehicle and slowly towed into position (e.g. over a highway). It is also contemplated that at least one of the individual clouds 12 could be equipped with a propulsion system, such as a remote-controlled solar-powered propeller, such as those used for drone systems, or even solar-powered drones. It could be controlled remotely by an operator or by an automatic control system with preset parameters. In this way, the mobile cloud system 10 can be moved to any desired location and can either remain mobile, or be anchored, either directly to the ground or to a fixed structure as discussed above. Alternatively, instead of the mobile cloud system 10 incorporating a propulsion system, the mobile cloud system 10 itself may be connected via cables 20 to one or more drones. Such drones may be remote-controlled.

In order to capture and use solar energy, in a further embodiment, the balloons 14 may be laminated with, or covered by, panels of amorphous silicon making up thin, flexible photovoltaic (PV) cells 30. In another embodiment, the PV cells 30 may be made integrally with the balloons 14, such as by 3-D printing. Alternatively, the balloons 14 may comprise any other similar product that converts solar energy from the sun's rays to electric energy. For example, a coating or paint containing PV materials based on nanotechnology is currently under development, whereby a surface coated with this paint would act as a PV cell and can convert the sun rays into electricity. Similarly, the sheets 16 may be made of thin, flexible PV cells 30. The PV cells 30 of adjacent clouds 12 are interconnected by electric cables 32 and linked to the ground station 34, which could then feed the converted solar energy to an electrical grid. In one embodiment, the cables 20 used for tethering the clouds 12 and the connectors 8 for interconnecting the individual clouds 12 may also function as electric cables 32. Alternatively, the ground station 34 could be connected to a battery bank (not shown) for storing the generated electrical current for future use. With advancing technologies, it is also contemplated that one day the electricity could be beamed down to the ground station 34 using an electromagnetic radiation system or the like, similar to the systems currently used for wirelessly charging cellular phones.

The ground stations 34 can be fixed or portable or mobile structures where the monitoring and other electrical equipment are housed, or they can be intermediate structures in between various other stations housing the equipment. Preferably, the electric cables 32 feed the electric current from the PV cells 30 to the ground station 34, which could house the converters and distribution boards/systems and batteries where needed.

When many clouds 12 are utilized, there may be a need for many small ground stations 34. In these cases, the ground stations 34 may also act as anchors 22 for the clouds 12 (in addition to acting as ground stations 34 for the electric cables 32 to pass electricity through to other ground stations 34 if needed). The size and number of ground stations 34 would depend on the amount of equipment being housed and the size and number of balloons 14 or sheets 16 forming the mobile cloud system 10.

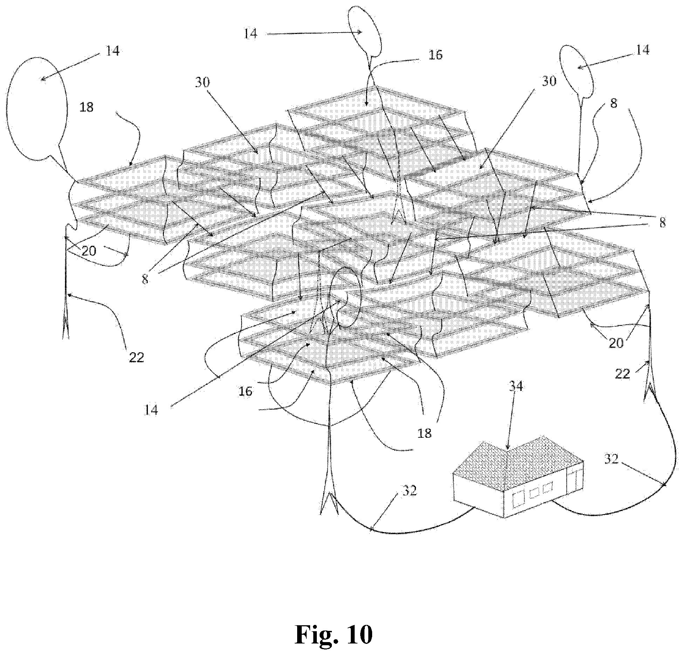

It is also contemplated that cloud systems 10 could be formed from vertical stacks of horizontally extending cloud 12, as shown in Fig. 10. Fig. 10 shows a cloud system 10 made up of a 3×3 grid, wherein each unit in the grid is made of a set of three sheets 16 stacked substantially vertically on top of each other. The sheets 16 are interconnected and held aloft by a plurality of balloons 14. This could further multiply the electricity being generated by the PV cells 30.

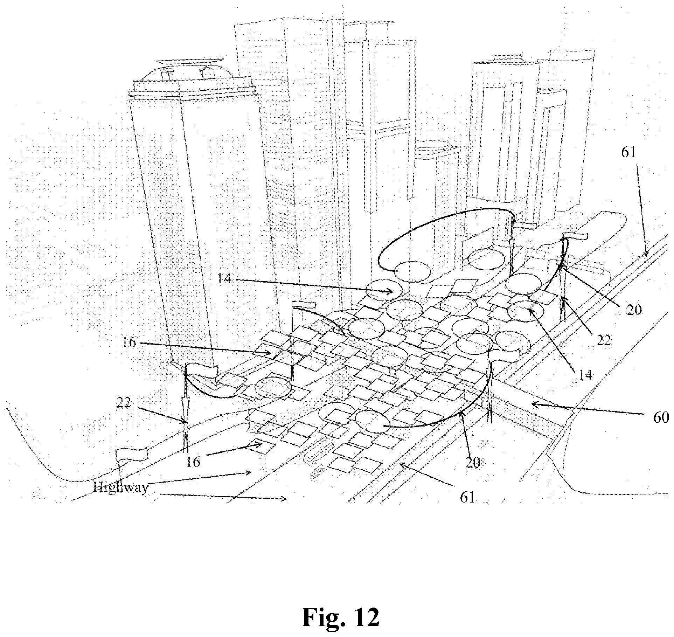

In an urban setting, the mobile cloud system 10 may be used to provide shade for pedestrians, and if equipped with the PV cells 30, for also to produce power. For example, a mobile cloud system 10 may be situated over a pedestrian walkway. The mobile cloud system 10 may provide shade, thereby lowering the temperature underneath and providing some relief for pedestrians, while also providing a source of electrical power that could in turn be used to power air-conditioning machinery for walkway tunnels. Referring to Fig. 12, this system may be integrated with a subway or transit network (e.g. with metro station 60 and metro tracks 61) so that the users can travel covered for larger distances and would only be exposed to the open climate for shorter periods of time. This would reduce the number and size of clouds systems 10 needed. It is also contemplated that the cloud system 10 may be used in conjunction with air-conditioned over-ground tunnels built to provide a new environment and comfortable atmosphere for visitors. These could be built in any areas with large numbers of pedestrians, for example on the main routes to a sporting event or concert area, such that large number of visitors would be able to move about with comfort during hot days.

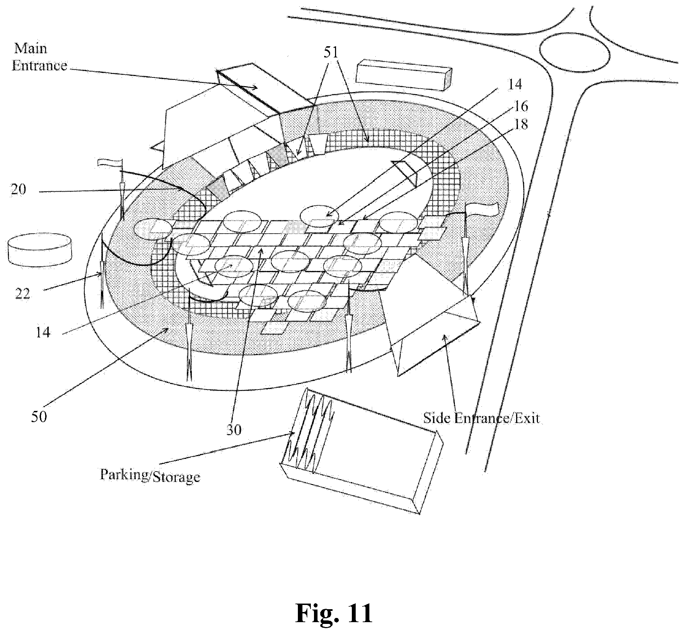

In another example shown in Fig. 11, a mobile cloud system 10 could be situated above an open-air stadium 50 (with spectator seating 51) in order to provide shade while still maintaining an open-air feel. The mobile cloud system 10 could be held in place by way of a plurality of zeppelins, which are already often in use above stadiums during large sporting events. Alternatively, the mobile cloud could be anchored to various anchors 22 spaced about the top of the stadium 50, as shown in Fig. 11. The cloud system 10 could also be launched from within the stadium 50. Individual clouds 12 could be spread on the ground and connected together, and then slowly raised using a motorized winch pulling on the ends while having some lighter-than-air gas pumped into the balloons 14 to assist the launch and lift. Alternatively, the clouds 12 can be inserted in a cavity of the roof of the stadium 50 and slowly pulled from one end to the other by cords or steel cables. After use, the mobile cloud system 10 can be reeled in by the motorized winch to a level where the gas can be removed or a computerized system can be devised to remove the gas from the clouds to attached canisters. This is ideal to provide instant and temporary shading for existing open-air stadiums or arenas for sports or musical venues. This can also be used to provide shelter from the rain in other situations and/or locations.

Being portable, this system may also be used to generate electricity in remote locations or for emergencies in times of natural disasters where other means of generating electricity are difficult or impossible or would be deemed too expensive or require more time to arrange. This is especially useful in remote or desert locations.

It is also contemplated that the bottom of the individual clouds 12 could be fitted with at least one light-producing device 50. The light-producing device 50 may be a light-emitting diode (LED). LED lights require little power. They could have a light-sensitive or automatic time switch, similar to ones used for street lighting. This light-producing device 50 may be used for the lighting of streets or large areas and also be used to create a pleasing visual effect (e.g. mood lighting or a fairytale-like effect with lighted panels/balloons high in the sky to give a pleasant and cheerful effect).

It is also contemplated that the surfaces of the individual clouds 12 may be used to carry advertising material. The advertising material may be affixed to or painted on the bottom or other surface of the clouds 12 or carried on banners below for viewing by the public, when the cloud system 10 is to be used in populated areas.

The balloons 14 and sheets 16 can be of various shapes and sizes, varying from very thin and flat like those of a paraglider to larger and round like a zeppelin and are or could be connected between them with the connectors 8. The material of the balloons 14 and sheets 16 is preferably of a plastic-type material that can be laminated with thin-film PV cells 30 and also be light enough for them to be carried to appropriate altitudes by the balloons 14.

So while it is possible to create as many mobile clouds of any size or shape or configuration, it is worthy to note that they would not occupy any land and consume space but on the contrary, they may be used to provide shade to the land below and even the degree and type and shape of shade can be controlled. They can be used to create shade for walkways in cities or shade for agricultural land where certain plantations have to be shaded for better effect.

The mobile cloud system 10 with PV cells 30 can be used over highways or railways that stretch for kilometres, and yet no land would be tied up with bulky solar collectors as is the case with the typical solar farms found on various continents. This would free up vast areas of land that can be used for many other purposes. Electricity generated can be used to power locations on the ground along the highway or railway (e.g. to enable electric cars or vehicles to be plugged in to charge/recharge, or simply to provide a supplementary source of power in the case of an electric train).

The mobile cloud system 10 with PV cells 30 can also be used over congested urban areas where there is no space on the ground for solar collectors.

It is also contemplated that observation cameras can be mounted to the bottom of individual clouds 12 for multiple purposes, from monitoring traffic or weather to providing video footage of open-air concerts or security video, all with control of the clouds 12 via a computer system.

The mobile cloud system 10 can act like real clouds in that that they can flex and bend and move like real clouds. For instance, the movement of the clouds 12 helps dissipate the heat absorbed by the PV cells 30, thus improving their performance. They have movement on all axes but in various degrees and are flexible almost like natural clouds. The shape and design of the clouds 12 help in absorbing the light from the sun at all angles and can keep the PV cells 30 working in a more efficient form. Fixed vertical PV panels, such as those used on glass windows, lose efficiency when they get too hot from the sun and need to have their backsides cooled to avoid loss of the photovoltaic activity. With the cloud system 10 of the present invention, the top and bottom layers (as well as the four sides) are exposed and oscillate even if gently and act as natural ventilators, and so heat is dissipated, and the temperature is better moderated for maximum PV efficiency.

It will be appreciated by those skilled in the art that the preferred embodiment has been described in some detail but that certain modifications may be practiced without departing from the scope of the claims.

## Claims

1. A mobile cloud system (10) comprising:
a plurality of panels (12) elevated above ground level, each one of said plurality of panels (12) comprising a sheet (16) of material formed of, laminated with or covered by means (30) for converting solar energy to electrical energy, wherein adjacent ones of said panels (12) are interconnected;
one or more anchors (22); and
one or more anchoring cables (20) extending between said anchors (22) and said plurality of panels (12),
wherein said panels (12) are tethered together by connecting cables (8) to form a generally horizontally-extending grid pattern,
**characterized in that** said sheet (16) is a sheet of flexible material
and **in that** at least some of said panels (12) at least partially overlap.

2. The mobile cloud system (10) of claim 1, wherein said connecting cables (8) and/or said anchoring cables (20) function as electric cables (32).

3. The mobile cloud system (10) of any one of the preceding claims, wherein said anchors (22) are located exterior to a footprint of said plurality of panels (12).

4. The mobile cloud system (10) of any one of the preceding claims, further comprising a frame structure (18) extending around at least one of said panels.

5. The mobile cloud system (10) of claim 4, wherein said frame structure (18) is made of a material capable of some flex.

6. The mobile cloud system (10) of claim 4 or claim 5, wherein said frame structure (18) comprises skeletal frame-like structures surrounding and connecting to said sheets (16), said skeletal frame-like structures including one or more hinges (13) for folding and unfolding the structures for transport.

7. The mobile cloud system (10) of any one of the preceding claims, wherein said plurality of panels (12) is tethered to the ground through said anchors (22), and wherein said plurality of panels (12) are elevated above ground level by balloons (14).

8. The mobile cloud system (10) of any one of claims 1-6, wherein said plurality of panels is tethered to one or more elevated structures on the ground by said anchoring cables (20).

9. The mobile cloud system (10) of claim 8, wherein said elevated structures are distributed around an upper surface of a stadium.

10. The mobile cloud system (10) of any one of the preceding claims, wherein one or more of said plurality of panels (12) comprises at least one light-emitting device (50).

11. The mobile cloud system (10) of any one of the preceding claims, wherein one or more of said plurality of panels (12) comprises one or more cameras.

12. The mobile cloud system (10) of any one of the preceding claims, further comprising a propulsion system connected to at least one of said plurality of panels (12).

13. The mobile cloud system (10) of any one of the preceding claims, wherein one or more of said plurality of panels (12) comprises advertising material on a bottom surface of said one or more of said plurality of panels (12).

14. The mobile cloud system (10) of any one of the preceding claims, wherein said anchors (22) are located along one or more sides of a roadway, pedestrian walkway, or rail track, and wherein said plurality of panels (12) is elevated above corresponding said roadway, pedestrian walkway, or rail track.

## Patentansprüche

1. Mobiles Wolkensystem (10), aufweisend:
mehrere Paneele (12), die über Bodenniveau angehoben sind, wobei jedes der mehreren Paneele (12) ein Materialblatt (16) umfasst, die aus Mitteln (30) zum Umwandeln von Sonnenenergie in elektrische Energie gebildet, damit laminiert oder damit bedeckt ist, wobei benachbarte der Paneele (12) miteinander verbunden sind;
eine oder mehrere Verankerungen (22); und
ein oder mehrere Verankerungsstränge (20), die sich zwischen den Verankerungen (22) und
den mehreren Paneelen (12) erstrecken,
wobei die Paneele (12) durch Verbindungsstränge (8) miteinander verbunden sind, um ein im allgemeinen horizontal verlaufendes Gittermuster zu bilden,
**dadurch gekennzeichnet, dass** das Blatt (16) ein Blatt aus flexiblem Material ist,
und dass zumindest einige der Paneele (12) sich zumindest teilweise überlappen.

2. Mobiles Wolkensystem (10) gemäß Anspruch 1, wobei die Verbindungsstränge (8) und/oder die Verankerungsstränge (20) als elektrische Kabel (32) fungieren.

3. Mobiles Wolkensystem (10) gemäß einem der vorangehenden Ansprüche, wobei die Verankerungen (22) außerhalb einer Grundfläche der mehreren Paneele (12) angeordnet sind.

4. Mobiles Wolkensystem (10) gemäß einem der vorangehenden Ansprüche, das ferner eine Rahmenstruktur (18) umfasst, die sich um mindestens eine der Paneele herum erstreckt.

5. Mobiles Wolkensystem (10) gemäß Anspruch 4, wobei die Rahmenstruktur (18) aus einem Material besteht, das sich etwas biegen kann.

6. Mobiles Wolkensystem (10) gemäß Anspruch 4 oder Anspruch 5, wobei die Rahmenstruktur (18) skelettartige Strukturen umfasst, die die Blätter (16) umgeben und mit ihnen verbunden sind, wobei die skelettartigen Strukturen ein oder mehrere Scharniere (13) zum Falten und Entfalten der Strukturen für den Transport umfassen.

7. Mobiles Wolkensystem (10) gemäß einem der vorangehenden Ansprüche, wobei die mehreren Paneele (12) durch die Verankerungen (22) am Boden befestigt sind, und wobei die mehreren Platten (12) mittels Ballonen (14) über Bodenniveau angehoben ist.

8. Mobiles Wolkensystem (10) gemäß einem der Ansprüche 1 bis 6, wobei die mehreren Paneele durch die Verankerungsstränge (20) an einer oder mehreren erhöhten Strukturen am Boden angebunden ist.

9. Mobiles Wolkensystem (10) gemäß Anspruch 8, wobei die erhöhten Strukturen um eine obere Fläche eines Stadions herum verteilt sind.

10. Mobiles Wolkensystem (10) gemäß einem der vorangehenden Ansprüche, wobei eine oder mehrere der mehreren Paneele (12) mindestens eine lichtemittierende Vorrichtung (50) aufweist.

11. Mobiles Wolkensystem (10) gemäß einem der vorangehenden Ansprüche, wobei eines oder mehrere der mehreren Paneele (12) eine oder mehrere Kameras aufweist.

12. Mobiles Wolkensystem (10) gemäß einem der vorangehenden Ansprüche, das ferner ein Antriebssystem aufweist, das mit mindestens einem der mehreren Paneele (12) verbunden ist.

13. Mobiles Wolkensystem (10) gemäß einem der vorangehenden Ansprüche, wobei eine oder mehrere der mehreren Paneele (12) Werbematerial auf einer Bodenfläche der einen oder mehreren der mehreren Paneele (12) umfasst.

14. Mobiles Wolkensystem (10) gemäß einem der vorangehenden Ansprüche, wobei die Verankerungen (22) entlang einer oder mehrerer Seiten einer Fahrbahn, eines Fußgängerwegs oder eines Schienenwegs angeordnet sind, und wobei die mehreren Paneele (12) über die entsprechende Fahrbahn, den Fußgängerweg oder den Schienenweg erhöht ist.

## Revendications

1. Système de nuage mobile (10) comprenant :
une pluralité de panneaux (12) élevés au-dessus du niveau du sol, chacun de ladite pluralité de panneaux (12) comprenant une feuille (16) de matériau formée de, laminée avec ou couverte par des moyens (30) pour la conversion d'énergie solaire en énergie électrique, dans lequel des panneaux adjacents parmi lesdits panneaux (12) sont interreliés ;
une ou plusieurs ancres (22) ; et
un ou plusieurs câbles d'ancrage (20) s'étendant entre lesdites ancres (22) et ladite pluralité de panneaux (12),
dans lequel lesdits panneaux (12) sont attachés ensemble par des câbles de raccordement (8) pour former un motif de grille s'étendant généralement horizontalement,
**caractérisé en ce que** ladite feuille (16) est une feuille de matériau flexible
et **en ce qu'**au moins certains desdits panneaux (12) se recouvrent au moins partiellement.

2. Système de nuage mobile (10) selon la revendication 1, dans lequel lesdits câbles de raccordement (8) et/ou lesdits câbles d'ancrage (20) fonctionnent comme des câbles électriques (32).

3. Système de nuage mobile (10) selon l'une quelconque des revendications précédentes, dans lequel lesdites ancres (22) sont situées à l'extérieur d'une empreinte de ladite pluralité de panneaux (12).

4. Système de nuage mobile (10) selon l'une quelconque des revendications précédentes, comprenant en outre une structure de cadre (18) s'étendant autour d'au moins un desdits panneaux.

5. Système de nuage mobile (10) selon la revendication 4, dans lequel ladite structure de cadre (18) est réalisée en un matériau capable d'une certaine flexion.

6. Système de nuage mobile (10) selon la revendication 4 ou la revendication 5, dans lequel ladite structure de cadre (18) comprend des structures de type cadre squelettique entourant et se raccordant auxdites feuilles (16), lesdites structures de type cadre squelettique comportant une ou plusieurs articulations (13) pour le pliage et le dépliage des structures pour le transport.

7. Système de nuage mobile (10) selon l'une quelconque des revendications précédentes, dans lequel ladite pluralité de panneaux (12) est attachée au sol à travers lesdites ancres (22), et dans lequel ladite pluralité de panneaux (12) est élevée au-dessus du niveau du sol par des ballons (14).

8. Système de nuage mobile (10) selon l'une quelconque des revendications 1 à 6, dans lequel ladite pluralité de panneaux est attachée à une ou plusieurs structures élevées sur le sol par lesdits câbles d'ancrage (20).

9. Système de nuage mobile (10) selon la revendication 8, dans lequel lesdites structures élevées sont distribuées autour d'une surface supérieure d'un stade.

10. Système de nuage mobile (10) selon l'une quelconque des revendications précédentes, dans lequel un ou plusieurs de ladite pluralité de panneaux (12) comprend au moins un dispositif d'émission de lumière (50).

11. Système de nuage mobile (10) selon l'une quelconque des revendications précédentes, dans lequel un ou plusieurs de ladite pluralité de panneaux (12) comprend une ou plusieurs caméras.

12. Système de nuage mobile (10) selon l'une quelconque des revendications précédentes, comprenant en outre un système de propulsion raccordé à au moins un de ladite pluralité de panneaux (12).

13. Système de nuage mobile (10) selon l'une quelconque des revendications précédentes, dans lequel un ou plusieurs de ladite pluralité de panneaux (12) comprend du matériau publicitaire sur une surface inférieure dudit un ou plusieurs de ladite pluralité de panneaux (12).

14. Système de nuage mobile (10) selon l'une quelconque des revendications précédentes, dans lequel lesdites ancres (22) sont situées le long d'un ou de plusieurs côtés d'une route, d'une allée piétonnière, ou d'une voie ferrée, et dans lequel ladite pluralité de panneaux (12) est élevée au-dessus de ladite route, de ladite allée piétonnière, ou de ladite voie ferrée correspondante.
